(19) Europäisches Patentamt
European Patent Office
Office européen des brevets

(11) Numéro de publication : **0 130 107**
**B1**

(12) **FASCICULE DE BREVET EUROPÉEN**

(45) Date de publication du fascicule du brevet : **19.08.87**

(51) Int. Cl.[4] : **H 03 H 19/00**

(21) Numéro de dépôt : **84401219.5**

(22) Date de dépôt : **14.06.84**

(54) **Filtre à capacités commutées simulant exactement un filtre LC.**

(30) Priorité : **24.06.83 FR 8310499**

(43) Date de publication de la demande : **02.01.85 Bulletin 85/01**

(45) Mention de la délivrance du brevet : **19.08.87 Bulletin 87/34**

(84) Etats contractants désignés : **DE FR GB IT NL**

(56) Documents cités :
**US-A- 4 315 227**
**IEEE TRANSACTIONS ON CIRCUITS AND SYSTEMS, vol. CAS-28, no. 8, août 1981, New York (US); M.S. LEE et al.: "Bilinear switched-capacitcr ladder filters", pages 811-821**
**IEEE TRANSACTIONS ON CIRCUITS AND SYSTEMS, vol. CAS-27, no. 6, juin 1980, New York (US); G. SZENTIRMAI et al.: "Switched-capacitor building blocks", pages 492-501**
**PROCEEDINGS OF THE 1981 EUROPEAN CONFERENCE ON CIRCUIT THEORY AND DESIGN, La Haye 25-28 août 1981, North Holland Publ. Cie., Amsterdam (NL), S. ERIKSSON: "An approach to the realization of switched-capacitor filters using the bilinear transformation", pages 803-807**
**1980 IEEE INTERNATIONAL SYMPOSIUM ON CIRCUITS AND SYSTEMS PROCEEDINGS, vol. 1/3, 28-30 avril 1980, Houston, Tx, New York (US); T. HUI et al.: "Mos switched capacitor highpass/notch ladder filters", pages 309-312**

(73) Titulaire : **THOMSON SEMICONDUCTEURS**
**101, bld Murat**
**F-75016 - Paris (FR)**

(72) Inventeur : **Caillon, Christian**
**THOMSON-CSF SCPI 173, bld Haussmann**
**F-75379 Paris Cedex 08 (FR)**
Inventeur : **Fensch, Thierry**
**THOMSON-CSF SCPI 173, bld Haussmann**
**F-75379 Paris Cedex 08 (FR)**

(74) Mandataire : **Guérin, Michel et al**
**THOMSON-CSF SCPI 19, avenue de Messine**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**EP 0 130 107 B1**

Jouve, 18, rue St-Denis, 75001 Paris, France

**Description**

La présente invention concerne les filtres à capacités commutées.

On sait actuellement bien réaliser des filtres à capacités commutées (et notamment des filtres passe-bas) qui sont essentiellement la transposition de filtres à inductances et capacités. On peut par exemple lire à ce sujet l'article de Josef Nossek et Gabor Temes dans IEEE Transactions on circuits and systems, vol. CAS-27 n° 6, juin 1980.

Le comportement d'un filtre à inductances et capacités est bien connu, et présente des propriétés intéressantes, notamment du point de vue de la stabilité du filtre et de sa faible sensibilité aux variations de valeur des composants qui le forment.

Ce comportement peut s'écrire sous forme d'une équation matricielle dans laquelle les inconnues sont les variables d'état du filtre (courant dans les inductances et tensions aux bornes des capacités), cette équation faisant intervenir la variable de Laplace s.

On peut remplacer, pour simuler le filtre LC par un filtre à capacités commutées, la variable s par la variable z des systèmes échantillonnés, ceci en utilisant des transformations connues (transformation bilinéaire ou transformation LDI par exemple).

La transformation bilinéaire présente un avantage important sur la transformation LDI (Lossless Discrete Integration) du fait que, contrairement à cette dernière, le filtre à capacités commutées qu'elle permet d'obtenir simule exactement le prototype LC et en particulier permet de conserver des résistances de terminaison réelles et non complexes, ce qui est indispensable si on veut obtenir une réponse en fréquence non déformée lorsqu'on s'approche de la fréquence d'échantillonnage. On s'intéresse donc ici uniquement à la transformation bilinéaire.

Par cette transformation, on aboutit à une nouvelle équation matricielle, en z, dont les inconnues représenteront par hypothèse les tensions de sorties d'amplificateurs opérationnels : c'est là le principe de base de la synthèse d'un filtre à capacités commutées simulant un filtre LC.

Que ce soit pour un filtre passe-bas ou d'autres types de filtres (passe-bande par exemple), on aboutit normalement à des schémas de filtres à capacités commutées ayant une entrée, une sortie, et au moins trois amplificateurs opérationnels ; dans ces schémas, l'entrée du filtre est normalement reliée à l'entrée d'un seul amplificateur opérationnel, et cette liaison se fait notamment par une capacité commutée d'un type qui a le défaut d'être très sensible aux capacités parasites. Cette capacité commutée est reliée d'une part directement à une masse et d'autre part à la fois à un interrupteur relié à l'entrée de l'amplificateur opérationnel et à un autre interrupteur (actionné en opposition de phase avec le premier) relié à l'entrée du filtre.

« L'article de G. Szentirmai et G. Temes dans IEEE transactions on Circuits and Systems vol. CAS-27 n° 6, juin 1980, décrit un filtre analogue dans lequel l'entrée du filtre est reliée aux entrées de chacun des amplificateurs opérationnels par des capacités commutées qui sont très sensibles aux capacités parasites ».

La présente invention propose un schéma de filtre modifié, qui ne comporte pas ce type de capacité commutée et qui possède pourtant exactement la même fonction de transfert globale (passe-bas ou passe-bande par exemple) ; cette modification de schéma entraîne l'adjonction d'un minimum de capacités supplémentaires.

Dans un filtre à capacités commutées selon le préambule de la revendication 1 dont l'entrée du filtre est reliée à l'entrée de chacun des trois amplificateurs opérationnels du filtre par trois capacités respectives, ce schéma est caractérisé en ce que la première étant une capacité commutée de fonction de transfert $-Cez^{-1}$ où Ce est une constante positive, la seconde étant une capacité non commutée de fonction de transfert $Ce.C22.(1-z^{-1})$ où C22 est une autre constante positive (pouvant être égale en particulier à la valeur d'une capacité de bouclage non commutée reliée entre la sortie et l'entrée du deuxième amplificateur opérationnel), et la troisième étant une capacité commutée de fonction de transfert égale à une constante positive (pouvant être égale en particulier à Ce).

On exposera dans la description quelle est la correspondance directe entre le schéma de commutation de ces capacités et leur fonction de transfert.

D'autres caractéristiques et avantages de l'invention apparaîtront à la lecture de la description détaillée qui suit et qui est faite en référence aux dessins annexés dans lesquels :

la figure 1 représente un exemple de filtre LC que l'on veut simuler exactement par un filtre à capacités commutées en utilisant la transformée bilinéaire ;

la figure 2 représente un schéma normal de filtre à capacités commutées simulant le filtre de la figure 1 ;

la figure 3 représente les différents types de capacités commutées ou non utilisées dans ce schéma ;

la figure 4 représente le schéma modifié selon l'invention.

Un exemple classique de filtre passe-bas du cinquième ordre (à inductances et capacités), est représenté à la figure 1 : il comporte une résistance équivalente d'entrée R, trois capacités C1, C2, C3, deux circuits bouchon L4,C4 et L5,C5, et une résistance de charge R' de même valeur que la résistance d'entrée R.

On peut écrire les équations qui régissent le comportement de ce filtre, où les inconnues seraient divers courants et tensions dans le filtre : V1, i2, V3, i4, V5 par exemple. On aboutit à une équation matricielle faisant intervenir la variable de Laplace s. Dans cette équation, en particulier, l'inconnue V5 est la tension de sortie du filtre passe-bas (voir figure 1) ; U est la tension appliquée à l'entrée du filtre.

Sans entrer dans le détail de l'établissement de l'équation matricielle, on voit facilement qu'on peut écrire, dans le schéma de la figure 1, par exemple V1 — V3 = L4 s i2 ; V5 — V3 = L5 s i2, etc., l'ensemble définissant une équation matricielle représentant le comportement électrique du filtre.

L'équation matricielle peut ête modifiée ensuite en remplaçant la variable s par $2(1 - z^{-1})/T(1 + z^{-1})$ où T est la période d'échantillonnage du filtre à capacités commutées qui doit simuler le filtre analogique de la figure 1. Ce changement de variable constitue ce qu'on appelle la transformation bilinéaire.

Par transformations successives de l'équation matricielle, on aboutit à une équation qui est la suivante :

$$\begin{vmatrix} 1+C11(1-z^{-1}) & 1 & C13(1-z^{-1}) & 0 & 0 \\ -z^{-1} & C22(1-z^{-1}) & -z^{-1} & 0 & 0 \\ C31(1-z^{-1}) & 1 & C33(1-z^{-1}) & 1 & C35(1-z^{-1}) \\ 0 & 0 & -z^{-1} & C44(1-z^{-1}) & -z^{-1} \\ 0 & 0 & C53(1-z^{-1}) & 1 & 1+C55(1-z^{-1}) \end{vmatrix} \begin{vmatrix} M \\ P \\ Q \\ R \\ S \end{vmatrix} = \begin{vmatrix} Ce(1+z^{-1}) \\ 0 \\ 0 \\ 0 \\ 0 \end{vmatrix} U \qquad (1)$$

M, P, Q, R, S représentent les inconnues V1, i2, V3, i4, V5 respectivement. Dans le schéma de filtre à capacités commutées M, P, Q, R, S seront les tensions de sortie respectives de cinq amplificateurs opérationnels A1, A2, A3, A4, A5 montés en intégrateurs, c'est-à-dire avec une capacité de bouclage entre leur sortie et leur entrée inverseuse.

Chaque ligne de l'équation matricielle exprime la nullité de la somme des courants convergeant à l'entrée de chaque amplificateur opérationnel.

On peut alors dessiner le schéma d'un filtre à capacités commutées, représenté à la figure 2 : chaque amplificateur est bouclé par une capacité de liaison directe (C11, C22, C33, C44, C55 respectivement). Les sorties des divers amplificateurs sont par ailleurs reliées aux entrées des autres (ou éventuellement du même) par des blocs de liaison apportant chacun une contribution de signal selon une certaine fonction de transfert qui est de la forme C ou $-Cz^{-1}$ ou $C(1 - z^{-1})$.

Ainsi, un bloc 11 de fonction de transfert 1 relie la sortie de l'amplificateur A1 à son entrée et apporte à cette dernière une contribution de signal 1 · M ; un bloc 12 de fonction de transfert 1 relie la sortie de l'amplificateur A2 à l'entrée de A1 et apporte à cette dernière une contribution de signal 1 · P ; une capacité de liaison directe (non commutée), C13, à une fonction de transfert $C13\,(1 - z^{-1})$ et relie la sortie de l'amplificateur A3 à l'entrée de l'amplificateur A1, de sorte qu'elle apporte à cette entrée une contribution $C13(1 - z^{-1})\,Q$ : la capacité de bouclage C11 de l'amplificateur A1 apporte quant à elle à l'entrée de cet amplificateur une contribution $C11(1 - z^{-1})\,M$. Enfin, l'entrée du filtre reçoit un signal E et est reliée à l'entrée de l'amplificateur A1 par deux blocs de liaison en parallèle, respectivement 10, de fonction de transfert $2Cez^{-1}$, et 20, de fonction de transfert $Ce(1 - z^{-1})$, qui apportent au total une contribution de signal $ECe(1 - z^{-1}) + 2ECez^{-1}$ soit $ECe(1 + z^{-1})$.

Au total à l'entrée de l'amplificateur A1, la nullité de la somme des courants se traduit par l'équation :

$$[1 + C11(1 - z^{-1})]\,M + P + C13(1 - z^{-1})\,Q + ECe(1 + z^{-1}) = 0$$

qui correspond bien à la première ligne de l'équation matricielle (1) à condition de faire E = — U, c'est-à-dire d'appliquer à l'entrée du filtre simulé l'opposé du signal qu'on aurait appliqué à l'entrée du filtre LC.

Le reste du schéma de la figure 2 s'établit exactement de la même manière à partir des autres lignes de l'équation matricielle en utilisant des blocs de fonction de transfert 1, $-z^{-1}$ et $C(1 - z^{-1})$ :

bloc 23 de fonction $-z^{-1}$ entre la sortie de A3 et l'entrée de A2 ;
bloc 32 de fonction 1 entre la sortie de A2 et l'entrée de A3 ;
bloc 43 de fonction $-z^{-1}$ entre la sortie de A3 et l'entrée de A4 ;
bloc 34 de fonction 1 entre la sortie de A4 et l'entrée de A3 ;
bloc 45 de fonction $-z^{-1}$ entre la sortie de A5 et l'entrée de A4 ;
bloc 54 (1) entre la sortie de A4 et l'entrée de A5 ;
bloc 55 (1) entre la sortie et l'entrée de A5 ;

capacité de liaison directe C31 de fonction $C31(1-z^{-1})$ entre la sortie de A1 et l'entrée de A3 ;
capacité de liaison directe C35, de fonction $C35(1-z^{-1})$ entre la sortie de A5 et l'entrée de A3 ;
capacité de liaison directe C53, de fonction $C53(1-z^{-1})$, entre la sortie de A3 et l'entrée de A5 ;
et bien entendu les capacités de bouclage non commutées entre la sortie de chaque amplificateur et son entrée, qui ont des fonctions de transfert en $C(1-z^{-1})$ où C est la valeur de la capacité considérée.

La figure 3 montre comment on réalise chacune des fonctions de transfert envisagées ci-dessus, soit par une capacité commutée, soit par une capacité non commutée :

à la ligne a, on rappelle simplement qu'un bloc de fonction $C(1-z^{-1})$ est constitué par une capacité non commutée de valeur C.

à la ligne b, un bloc de fonction C (par exemple C = 1) est réalisé par une capacité commutée de valeur C, avec un commutateur K1 pour relier une de ses extrémités soit à une borne de raccordement du bloc de liaison, soit à la masse et un commutateur K2 pour relier l'autre extrémité de la capacité, soit à l'autre borne de raccordement du bloc de liaison, soit à la masse ; les commutateurs K1 et K2 sont actionnés en phase, les deux extrémités de la capacité étant reliées à la masse dans l'une des phases et aux bornes du bloc de liaison dans l'autre phase ;

à la ligne c, la fonction de transfert $-Cz^{-1}$ est réalisée par une capacité commutée C (par exemple C = 1) reliée d'un côté à un commutateur K4 et de l'autre à un commutateur K5 ; dans une première phase, le commutateur K4 relie une première extrémité de la capacité à une borne du bloc de liaison et le commutateur K5 relie l'autre extrémité à la masse ; dans une autre phase, le commutateur K4 relie la première extrémité à la masse et le commutateur K5 relie l'autre extrémité à l'autre borne du bloc.

à la ligne d, la fonction de transfert $Cz^{-1}$ est réalisée par une capacité commutée C (par exemple C = 2Ce pour le bloc 10) reliée d'une part à la masse et d'autre part à un commutateur K3 qui permet de la relier pendant une phase à une borne du bloc de liaison et pendant une autre phase à l'autre borne.

Ce dernier type de capacité commutée n'apparaît qu'entre l'entrée du filtre et l'entrée de l'amplificateur A1 (bloc 10) ; il est dû à la nécessité de réaliser le second membre $Ce(1+z^{-1})\,U$ de l'équation (1).

Mais ce type de capacité, contrairement aux autres est très sensible aux capacités parasites qui sont importantes en technologie MOS (Metal-Oxyde-Semiconducteur), et on souhaite l'éviter dans le circuit ; en effet, les capacités des transistors interrupteurs constituant le commutateur K3 viennent se rajouter en parallèle sur la capacité principale à commuter et modifient sa valeur d'une manière mal connue.

Pour supprimer cette capacité, l'invention propose de repartir de l'équation (1) et de modifier la deuxième inconnue P en la remplaçant par $P' = (P-CeU)$.

L'équation (1) s'écrit alors :

$$\begin{vmatrix} 1+C11\,(1-z^{-1}) & 1 & C13\,(1-z^{-1}) & 0 & 0 \\ -z^{-1} & C22(1-z^{-1}) & -z^{-1} & 0 & 0 \\ C31\,(1-z^{-1}) & 1 & C33\,(1-z^{-1}) & 1 & C35(1-z^{-1}) \\ 0 & 0 & -z^{-1} & C44(1-z^{-1}) & -z^{-1} \\ 0 & 0 & C53\,(1-z^{-1}) & 1 & 1+C55(1-z^{-1}) \end{vmatrix} \begin{vmatrix} M \\ P-CeU \\ Q \\ R \\ S \end{vmatrix}$$

$$= \begin{vmatrix} Ce\,(1+z^{-1}) - Ce \\ -CeC22\,(1-z^{-1}) \\ -Ce \\ 0 \\ 0 \end{vmatrix} U \qquad (2)$$

Les éléments retranchés au premier membre de l'équation, par l'introduction de $-CeU$ dans la deuxième inconnue, doivent en effet être retranchés dans chaque ligne du second membre.

En reportant tous les termes de l'équation (2) du côté droit on aboutit à l'équation matricielle suivante :

$$\begin{vmatrix} \text{matrice inchangée} \\ \text{de l'équation (1)} \end{vmatrix} \begin{vmatrix} M \\ P' \\ Q \\ R \\ S \end{vmatrix} + \begin{vmatrix} -Cez^{-1} \\ CeC22(1-z^{-1}) \\ Ce \\ 0 \\ 0 \end{vmatrix} U = 0$$

Cette équation peut être mise en œuvre dans un schéma de filtre représenté à la figure 4, qui est modifié par rapport à celui de la figure 2 de la manière suivante :

1) les tensions de sortie des amplificateurs opérationnels représentent maintenant des inconnues M, P', Q, R, S ;

2) la tension appliquée à l'entrée du filtre est maintenant E = U et non E = — U pour obtenir la même tension S (même fonction de filtrage passe-bas) sur la sortie du cinquième amplificateur opérationnel A5 ;

3) les blocs 10 et 20 sont remplacés par un bloc unique 10' de fonction de transfert — $Cez^{-1}$, c'est-à-dire par une capacité commutée du type de la figure 3 ligne c et de valeur Ce ;

4) un bloc de liaison 30, de fonction de transfert CeC22 $(1 - z^{-1})$, c'est-à-dire une capacité non commutée de valeur CeC22 est placé entre l'entrée E du filtre et l'entrée du deuxième amplificateur opérationnel A2 ;

5) un bloc de liaison 40, de fonction de transfert Ce, c'est-à-dire une capacité commutée de type de la figure 3 ligne b, de valeur Ce, est placé entre l'entrée E du filtre et l'entrée du troisième amplificateur opérationnel.

On vérifie, par un calcul de déterminants, que la tension de sortie S, exprimée en fonction de la variable $z^{-1}$ et de la tension d'entrée E n'a subi aucune modification après ce changement d'équation matricielle et le changement de schéma correspondant.

On vérifie aussi que le schéma de la figure 4 ne comporte plus aucune capacité commutée de fonction de transfert $+ z^{-1}$ (du type de la figure 2d) qui est particulièrement sensible aux capacités parasites.

De plus, le schéma de la figure 4 ne comporte qu'une capacité supplémentaire (blocs 30 et 40 en plus, bloc 20 en moins) par rapport au schéma de la figure 2.

Cette modification de schéma est applicable de la même manière et aboutit au même résultat avec des valeurs numériques de capacités éventuellement différentes, pour un filtre passe-bande.

Dans la réalisation pratique des filtres à capacités commutées désirées, les schémas blocs du type de la figure 2 ou 4 doivent être traduits concrètement par des schémas à transistors, notamment en passant par l'utilisation des schémas de la figure 3 ; on remarquera alors que si plusieurs blocs de liaison aboutissent au même point, certains interrupteurs peuvent devenir redondants et donc inutiles ; on les supprimera dans ce cas.

**Revendications**

1. Filtre à capacités commutées simulant un filtre à inductances et capacités, comprenant au moins trois amplificateurs opérationnels (A1, A2, A3) bouclés chacun par une capacité non commutée (C11 à C33), avec des capacités commutées ou non entre la sortie de chaque amplificateur et l'entrée d'au moins un autre ou du même amplificateur, le filtre comportant une entrée de signal (E) et une sortie (S), l'entrée du filtre étant reliée à l'entrée d'un premier, d'un deuxième et d'un troisième amplificateurs opérationnels, par trois capacités respectives, caractérisé en ce que la première (10') de ces trois capacités est une capacité commutée correspondant à une fonction de transfert — $Cez^{-1}$ où Ce est une constante positive, la deuxième (30) est une capacité non commutée de fonction de transfert Ce.C22 $(1 - Z^{-1})$ où C22 est une autre constante positive, et la troisième (40) est une capacité commutée correspondant à une fonction de transfert égale à une constante positive.

2. Filtre selon la revendication 1, caractérisé en ce que la constante C22 positive est la valeur de la capacité de bouclage non commutée du deuxième amplificateur (A2).

3. Filtre selon l'une des revendications 1 et 2, caractérisé en ce que la troisième capacité commutée a la même valeur que la première.

**Claims**

1. Switched capacities filter simulating a filter with inductancies and capacities, comprising at least three operational amplifiers (A1, A2, A3) each of which is looped by an unswitched capacity (C11 to C33), with switched or unswitched capacities between the output of each amplifier and the input of at least one other or of the same amplifier, the filter comprising a signal input (E) and an output (S), the input of the filter being connected to the inputs of a first, second and third operational amplifiers through a respective one of three capacities, characterized in that the first (10') of these three capacities is a switched capacity corresponding to a transfer function — $Cez^{-1}$ wherein Ce is a positive constant, the second (30) is an unswitched capacity having the transfer function Ce.C22 $(1 - Z^{-1})$ wherein C22 is another positive constant, and the third (40) is a switched capacity corresponding to a transfer function equal to a positive constant.

2. Filter according to claim 1, characterized in that the positive constant C22 is the value of the unswitched looping capacity of the second amplifier (A2).

3. Filter according to claim 1 or 2, characterized in that the third switched capacity has the same value as the first.

**Patentansprüche**

1. Filter mit geschalteten Kapazitäten, durch welches ein Filter mit Induktivitäten und Kapazitäten simuliert wird, mit wenigstens drei Operationsverstärkern (A1, A2, A3), die jeweils durch eine ungeschaltete Kapazität (C11 bis C33) geschleift sind, mit geschalteten oder ungeschalteten Kapazitäten zwischen dem Ausgang jedes Verstärkers und dem Eingang wenigstens eines anderen oder desselben Verstärkers, wobei das Filter einen Signaleingang (E) und einen Ausgang (S) aufweist und der Eingang des Filters mit dem Eingang eines ersten, eines zweiten bzw. dritten Operationsverstärkers über je eine zugehörige Kapazität verbunden ist, dadurch gekennzeichnet, daß die erste (10') dieser drei Kapazitäten eine geschaltete Kapazität ist, welche einer Übertragungsfunktion $-Cez^{-1}$ entspricht, worin Ce eine positive Konstante ist, die zweite (30) eine ungeschaltete Kapazität mit der Übertragungsfunktion $Ce.C22 (1 - z^{-1})$ ist, worin C22 eine weitere positive Konstante ist, und die dritte (40) eine geschaltete Kapazität ist, welche einer Übertragungsfunktion entspricht, die gleich einer positiven Konstanten ist.

2. Filter nach Anspruch 1, dadurch gekennzeichnet, daß die positive Konstante C22 der Wert der ungeschalteten Schleifenkapazität des zweiten Verstärkers (A2) ist.

3. Filter nach Anspruch 1 oder 2, dadurch gekennzeichnet, daß die dritte geschaltete Kapazität denselben Wert wie die erste aufweist.

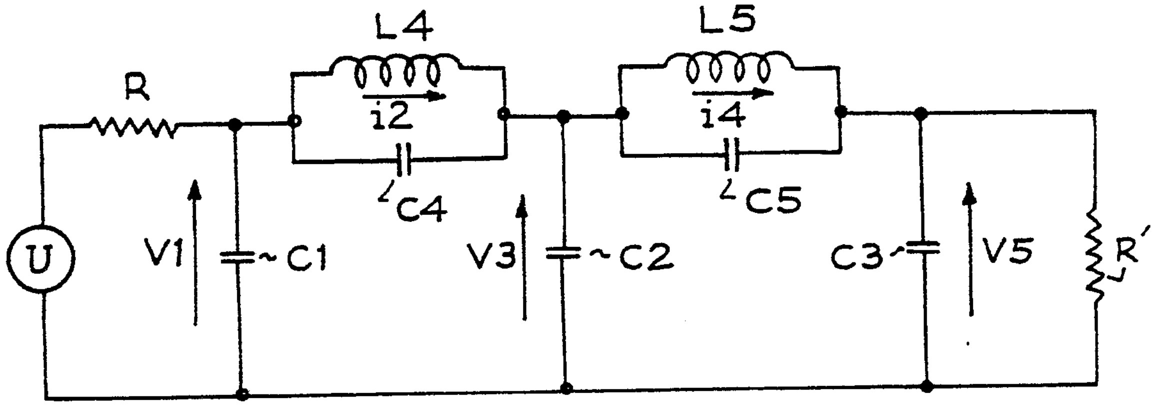
L4
L5
R
i2
i4
C4
C5
U
V1
C1
V3
C2
C3
V5
R'

Fig. 1

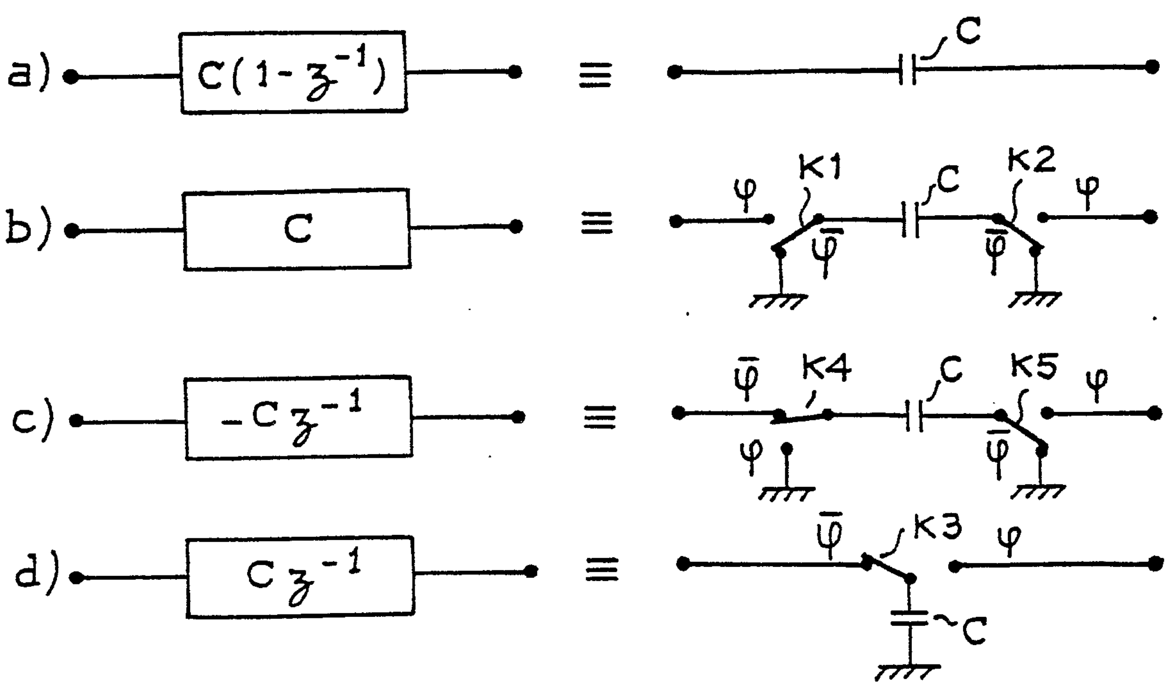
a)
C(1-z⁻¹)
≡
C
b)
C
≡
φ
K1
C
K2
φ
φ̄
φ̄
c)
-Cz⁻¹
≡
φ̄
K4
C
K5
φ
φ
φ̄
d)
Cz⁻¹
≡
φ̄
K3
φ
C

Fig. 3

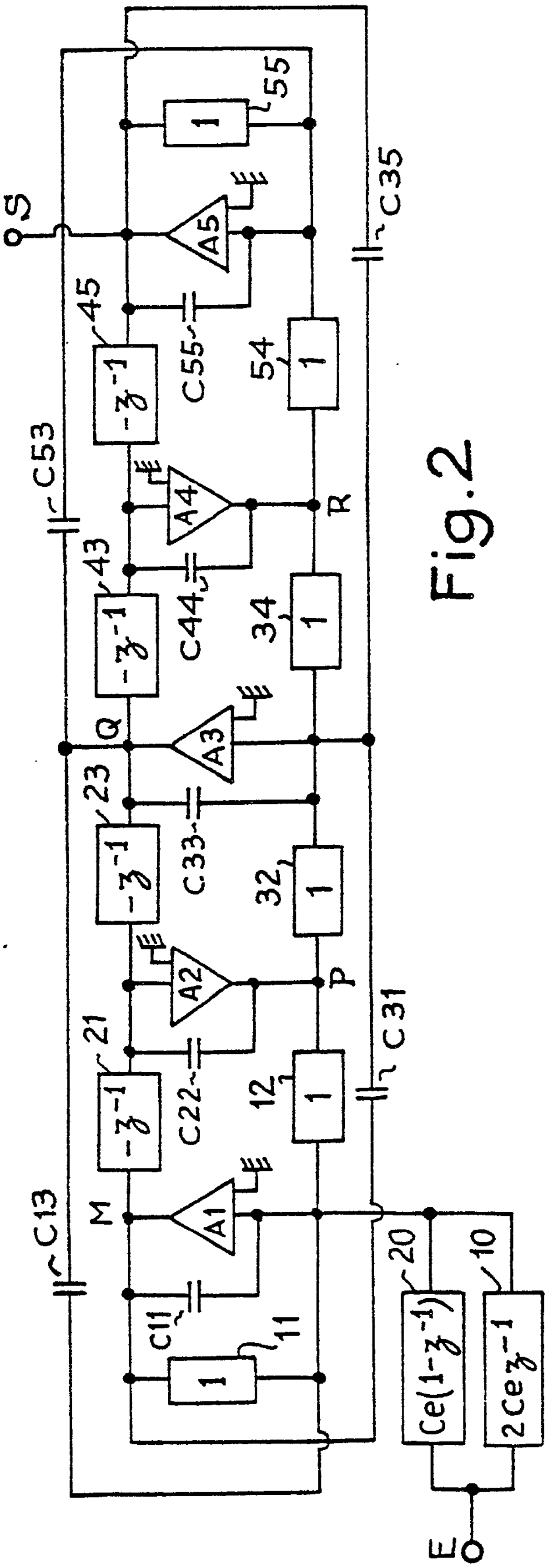

S
E
M
Q
P
R
A1
A2
A3
A4
A5
C11
C13
C22
C31
C33
C35
C44
C53
C55
11
12
20
21
23
32
34
43
45
54
55
10
$-z^{-1}$
1
Ce(1-$z^{-1}$)
2Ce$z^{-1}$


Fig.2

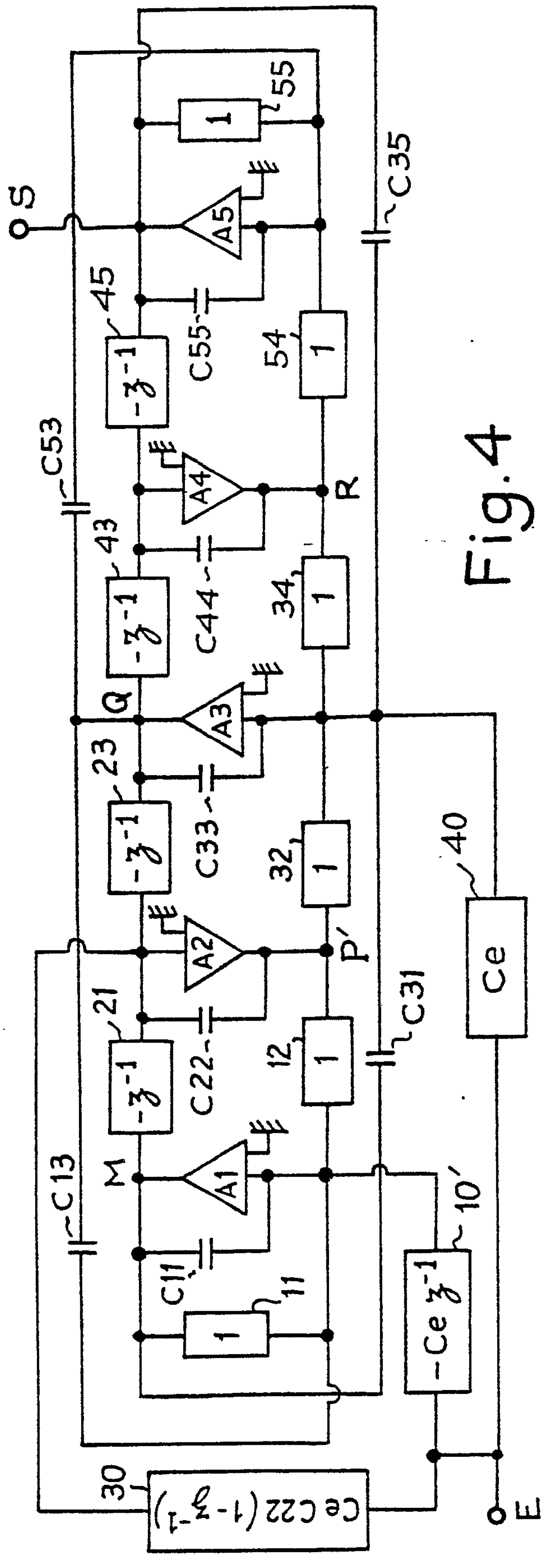

S
E
M
Q
P'
R
A1
A2
A3
A4
A5
C11
C13
C22
C31
C33
C35
C44
C53
C55
10'
11
12
21
23
30
32
34
40
43
45
54
55
$-z^{-1}$
1
Ce
-Ce$z^{-1}$
Ce C22 (1-$z^{-1}$)


Fig.4